# EUROPEAN PATENT APPLICATION

(11) **EP 4 592 423 A1**
(43) Date of publication of application: **30.07.2025**
(21) Application number: 22970288.1
(22) Date of filing: 26.12.2022
(51) Int. Cl.: C23C 26/00, C23C 28/00, G02B 1/10, B32B 37/14, B32B 33/00, B82Y 30/00, B82Y 40/00

(54) **METHOD FOR PRODUCING A METAL-CONTAINING FILM BLANK**

(71) Applicant: XPANCEO Research On Natural Science L.L.C., Dubai (AE)
(72) Inventor: ARSENIN, Aleksey Vladimirovich, Moscow, 127204 (RU); VOLKOV, Valentyn, Moscow, 127204 (RU); MIRONOV, Mikhail Sergeevich, Moscow, 127204 (RU); SYUY, Alexander Vyacheslavovich, Moscow, 127204 (RU)
(74) Representative: COPA Copenhagen Patents
(86) International application number: PCT/RU2022/000392
(87) International publication number: WO 2024/144412

(57) **Abstract**

The invention relates to a method of producing (Ω) a metal-containing film blank (1), wherein said method comprises the following steps: apply (E₁) an underlying layer onto a base; deposit (E₂) a metal to form a multilayer composite structure; place (S₁) the structure (10) into a liquid (M₁); destroy (S₂) the underlying layer (101).

According to the invention, the underlying layer (101) contains copper. The film (100) contains a noble metal.

Also, the invention relates to a method of applying (Ψ) said blank (1) to coat the target carrier (2) and to the use of the latter.

## Description

The invention relates to the field of optoelectronics and in particular to the process of producing thin metal films on target carriers, for example, on (light-) transmissive target carries, such as glass.

The term "thin" in the context of metal films means that the thickness of such films, as a rule, does not exceed 0.5 micrometers, hereafter denoted as µm.

According to the first of its aspects, the invention relates to a method of producing a metal-containing film blank adapted to be applied onto a target carrier. This method of producing comprises:
- a phase of forming a multilayer composite structure comprising a metal film,
   and
- a phase of destroying this multilayer composite structure to produce a metal-containing film blank.
Therewith, the phase of destroying the multilayer composite structure follows the phase of forming the multilayer composite structure. Under these conditions, the phase of forming the multilayer composite structure comprises further steps that are aimed to:
- apply an underlying layer onto a base to form a substrate layer,
- deposit a metal onto the substrate layer to form a multilayer composite structure containing a metal film bonded with the substrate layer.
Therewith, the phase of destroying this multilayer composite structure comprises further steps that are aimed to:
- place a part of the multilayer composite structure into a first liquid medium,
- destroy the underlying layer.

This method of producing is known and disclosed in the Russian Federation patent RU2329875C2. Disadvantage of this prior art method of producing a metal film blank adapted to be applied onto a target carrier is that its integrity (i.e. solidity) can only be achieved with the metal film blank being thicker than 30 nanometers (hereinafter - nm). Such metal film thickness prevents the rays of visible light from passing through the film. Thus, it is impossible to provide the required transmission capacity (in the optical band of the light spectrum visible to the human eye) of the metal film blank produced using the prior art method as per RU2329875C2, which is unacceptable.

Attempts to use the prior art method as per RU2329875C2 to produce a metal film blank thinner than 30 nm result in forming a plurality of scattered, i.e. separated from each other, islands (spots) of metal irregular in thickness and form. The latter are not of expected smoothness, solidity and sufficient cohesion with each other to form a continuous film-type coating. Furthermore, such a plurality of scattered islands (spots) of metal is characterized by insufficient current conductivity, which is unacceptable.

Based on this unique observation, the present invention is mainly intended to suggest a method of producing a metal film blank adapted to be applied onto a target carrier, which makes it possible to at least mitigate minimum one of the above disadvantages. To achieve this goal, the method of producing a metal film blank corresponding to the general description given in the introduction above is characterized substantially in that the underlying layer contains copper. The metal film contains at least one metal from the following group of metals: (a) aurum; (b) argentum; (c) platinum; (d) ruthenium; (e) rhodium; (f) palladium; (g) osmium; (h) iridium.

Owing to high adhesive properties between a metal from the above group (i.e. aurum, or argentum, or platinum, or ruthenium, or rhodium, or palladium, or osmium, or iridium) and copper, it is possible to produce a metal film blank thinner than 30 nm, having sufficient smoothness, solidity and cohesion, which provides both sufficient transmission capacity in the optical band of the light spectrum visible to the human eye and high (electrical) current conductivity. Synergy, i.e. simultaneous combination, of these two advantages expands functionality of the method of producing a metal film blank according to the invention.

Preferably, the first liquid medium contains electrolyte. Under these conditions, the phase of destroying the multilayer composite structure additionally includes further steps that are aimed to:
- introduce into the first liquid medium the first electrode that is different from the multilayer composite structure.
- form an anode by connecting the first electrode to the positive pole of an external direct current supply,
- form a cathode by connecting the underlying layer to the negative pole of said external direct current supply, wherein said negative pole is different from the positive pole,
- establish an electrolytic process inside the first liquid medium between the cathode and anode, with electrolytic gas bubbles being produced inside the first liquid medium along the edge of the underlying layer contacting the first liquid medium,
- maintain said electrolytic process inside the first liquid medium between the cathode and anode to mechanically tear the underlying layer by said electrolytic gas bubbles away from the base,
- immerse the multilayer composite structure into the first liquid medium, while the underlying layer is separating from the base, until the underlying layer is fully separated from the base and a sandwich structure is formed comprising the underlying layer and the metal film bonded together.

Owing to said advantageous characteristics, electrolytic gas bubbles are produced inside the first liquid medium, along the edge of the underlying layer contacting the first liquid medium. The produced electrolytic gas bubbles engage the multilayer composite structure, penetrate between the base and the sandwich structure consisting of underlying layer and metal film. Expanding in volume, said electrolytic gas bubbles gradually tear the sandwich structure off the base. Additionally, the electrolytic gas bubbles help (the surface tension force acting upon the sandwich structure) to maintain positive buoyancy of said sandwich structure (once it is separated from the base) on the surface of the first liquid medium. The process of tearing away the sandwich structure and the base forms a crack, i.e. a defect in the multilayer composite structure, representing the areas with fully broken interatomic bonds (crack face) and partially broken interatomic bonds (crack tip). The crack face separation surface is the crack front. With the progress of crack growth (i.e. as the sandwich structure separates from the base), the first liquid medium (i.e. electrolyte) penetrates (flows) towards the crack tip, promoting the electrolytic process, thereby producing additional electrolytic gas bubbles in the immediate vicinity of the crack tip. Said additional electrolytic gas bubbles further open the crack faces contributing to the crack growth until the sandwich structure has completely separated from the base. Therewith, the effect of the electrolytic gas bubbles upon the sandwich structure does not cause mechanical damages to the latter, such as rupture, warping, clumping, conglutination. Thereby, further manipulations with the sandwich structure are simplified, which contributes to expansion of the metal film blank functionality according to the invention.

Herewith, it is crucial that the cathode is formed specifically on the multilayer composite structure underlying layer, as it is specifically on the underlying layer that the electrolytic gas bubbles needed to tear said underlying layer away from the base must form.

Preferably, the electrolyte consists of potassium chloride solution whose molar concentration is within the range from 0.05 mol per liter to 7.6 mol per liter.

Such specific choice of potassium chloride solution as an electrolyte is explained by its availability, ease of producing and low toxicity for the operator and environment. Thereby, the method, according to the invention, can be adapted to commercially produce the metal-containing film blank on a mass production basis, including under artificial limitation of the range of available chemical reagents. The selective choice of the potassium chloride solution molar concentration in the range from 0.05 mol per liter to 7.6 mol per liter makes it possible during the electrolytic process to produce the required amount of electrolytic gas bubbles sufficient to separate the base from the sandwich structure without mechanical damages to the latter. This contributes to reduced percentage of defective articles in mass production.

According to the first embodiment of the method of producing, according to the invention, the step of destroying the underlying layer includes a step that is aimed to replace the first liquid medium with a second liquid medium that is chemically aggressive to the underlying layer, to chemically etch the latter.

Owing to such characteristic, the metal film can be released from the underlying layer by chemical destruction of the latter. Herewith, the etching rate can be finely regulated by increasing or decreasing the speed of replacing the first liquid medium with the second liquid medium. This contributes to reduced percentage of defective articles in mass production.

According to the second embodiment of the method of producing, according to the invention, which is alternative to the first embodiment described above: the step of destroying the underlying layer includes a step that is aimed to transfer the sandwich structure containing the underlying layer and the metal film bonded together from the first liquid medium into the second liquid medium that is chemically aggressive to the underlying layer, to chemically etch the latter.

In this second embodiment of the method of producing, according to the invention, the chemical etching process goes faster than in the first embodiment described above, as the sandwich structure is exposed to the chemically aggressive second liquid medium instantaneously (i.e. as soon as the sandwich structure is transferred into the second liquid medium). Thereby, the method, according to the invention, can be adapted to commercially produce the metal-containing film blank on a mass production basis.

Preferably, the second liquid medium consists of one of the following solutions: (a) ammonium persulphate solution; (b) sodium persulphate solution; (c) hydrogen peroxide and sodium persulphate solution; (d) sulphuric acid solution; (e) sulphuric acid and hydrogen peroxide solution.

Such specific choice of the above described solutions as the second liquid medium is explained by their availability and ease of producing. Thereby, the method, according to the invention, can be adapted to commercially produce the metal-containing film blank on a mass production basis, including under artificial limitation of the range of available chemical reagents.

According to the third embodiment of the method of producing, according to the invention, the phase of destroying the multilayer composite structure can additionally include a step that is aimed to replace the second liquid medium with distilled water to remove the products of chemical reactions.

Rinsing with distilled water reliably removes any residual salts of the first liquid medium and/or residual salts of the second liquid medium which in case of their accidental crystallization may adversely affect the metal film integrity. Therewith, the chemical reaction products removal rate can be finely regulated by increasing or decreasing the speed of replacing the second liquid medium with distilled water. This contributes to reduced percentage of defective articles in mass production.

According to the fourth embodiment of the method of producing, according to the invention, which is alternative to the third embodiment described above: the phase of destroying the multilayer composite structure additionally includes a further step that is aimed to transfer the metal film from the second liquid medium into distilled water to remove the products of chemical reactions.

Rinsing with distilled water reliably removes any residual salts of the first liquid medium and/or residual salts of the second liquid medium which in case of their accidental crystallization may adversely affect the metal film integrity. In this fourth embodiment of the method of producing, according to the invention, the process of removing the products of chemical reactions goes faster that in the third embodiment described above as the transfer of the metal film into distilled water occurs instantaneously. Thereby, the method, according to the invention, can be adapted to commercially produce the metal-containing film blank on a mass production basis.

Preferably, the phase of destroying the multilayer composite structure additionally includes a further step that is aimed to achieve flotation of the sandwich structure on the surface of the first liquid medium after the underlying layer is completely separated from the base.

Flotation on the surface of the first liquid medium additionally guards the sandwich structure (after its underlying layer is completely separated from the base) from mechanical damages, such as, for example, rupture, warping, clumping, conglutination, during the process of replacement of the first liquid medium with the second liquid medium. Thereby, the method, according to the invention, can be adapted to commercially produce the metal-containing film blank on a mass production basis.

Preferably, the phase of destroying the multilayer composite structure additionally includes a step that is aimed to achieve flotation of the sandwich structure on the surface of the second liquid medium during the chemical etching of the underlying layer.

Flotation on the surface of the second liquid medium additionally guards the sandwich structure (after its underlying layer is completely separated from the base) from mechanical damages, such as, for example, rupture, warping, clumping, conglutination, during the process of the proper chemical etching of the underlying layer, as well as during the process of subsequent replacement of the second liquid medium with distilled water. Thereby, the method, according to the invention, can be adapted to commercially produce the metal-containing film blank on a mass production basis.

Preferably, the phase of destroying the multilayer composite structure additionally includes a further step that is aimed to achieve flotation of the metal film on the surface of distilled water during the removal of the products of chemical reactions.

Flotation on the surface of distilled water guards the metal film from mechanical damages, such as, for example, rupture, warping, clumping, conglutination, during the removal of the products of chemical reactions.

Preferably, the base contains one of the following materials: (a) a monocrystalline silicon wafer; (b) a monocrystalline silicon wafer with a layer of graphene pre-applied thereon; (c) a monocrystalline silicon wafer containing silicon oxide; (d) a monocrystalline silicon wafer containing silicon oxide, with a layer of graphene pre-applied thereon; (e) glass; (f) sapphire; (g) copper foil; (h) poly(4,4'-oxidiphenyl-pyromellitimide); (i) polyethyleneterephthalate; (j) polyether; (k) polypropylene; (l) polyethylene; (m) polyvinylchloride; (n) polystyrene; (o) polytetrafluoroethylene; (p) polymethylmethacrylate.

Owing to the wide choice of materials for the base, the method, according to the invention, can be adapted to commercially produce the metal-containing film blank on a mass production basis, including under artificial limitation of the range of available materials.

Preferably, the first thickness of the underlying layer is in the first range from 20 nanometers to 10,000 nanometers. Under these conditions, the second thickness of the metal film is in the second range from 0.5 nanometers to 30 nanometers.

Owing to these advantageous characteristics, the method, according to the invention, can be adapted to commercially produce the metal-containing film blank on a mass production basis, wherein each production stage is limited in terms of time and percentage of defective articles.

Preferably, the immersion of the multilayer composite structure into the first liquid medium, while the underlying layer is separating from the base, occurs along a guideline that makes an angle contained in the third range from 5° to 15° relative to the gravitational vector.

Owing to this advantageous characteristic, the separation of the underlying layer from the base goes in a most efficient manner, due to which fact the method, according to the invention, can be adapted to commercially produce the metal-containing film blank on a mass production basis. Furthermore, said angle from 5° to 15° relative to the gravitational vector is easy to monitor by the operator, which makes the operator's job easier and minimizes fatigue (which is particularly important when working at nights).

Preferably, the phase of forming the multilayer composite structure additionally includes a further step that is aimed to coat the metal film with a protective layer of polymer.

Owing to this advantageous characteristic, the stiffness of the sandwich structure containing the underlying layer and the metal film can be increased. This additionally guards the sandwich structure (after its underlying layer is completely separated from the base) from mechanical damages, such as, for example, rupture, warping, clumping, conglutination, in the course of operator's manipulations.

The protective layer of polymer as well increases the stiffness of the metal film itself after the chemical etching of the underlying layer has finished. This additionally guards the metal film from mechanical damages, such as, for example, rupture, warping, clumping, conglutination, in the course of operator's manipulations.

Thus, the method, according to the invention, is adapted to commercially produce the metal-containing film blank on a mass production basis, wherein each production stage is limited in terms of time, percentage of defective articles and should be comprehensible to an operator regardless of his/her qualification.

Preferably, the polymer contains one of the following materials: (a) polymethylmethacrylate; (b) polydimethylsiloxane, (c) polycarbonate, (d) polylactide; (e) polyphthalamide; (f) bisphenol A.

The choice of material for the protective layer of polymer from the list above is explained by that these materials are available and easy to produce. Thereby, the method, according to the invention, can be adapted to commercially produce the metal-containing film blank on a mass production basis, including under artificial limitation of the range of available polymers.

According to the second of its aspects, the invention relates to a method of coating a target carrier with a metal-containing film blank produced in accordance with the method of producing described above. Herewith, the method of coating comprises further steps that are aimed to:
- transfer the metal-containing film blank onto the target carrier,
- subject this metal-containing film blank to dehumidification after it has been transferred onto the target carrier,

Owing to said advantageous characteristics, it is possible to produce a target carrier coated with a homogeneous metal film, wherein said film is at the same time transparent (in the visible spectrum of radiation), current-conducting, and corrosion-resistant.

Preferably, the method of coating the target carrier with a metal-containing film blank produced according to the method of producing described above comprises the phase of forming the multilayer composite structure that additionally includes a step aimed to coat the metal film with a protective layer of polymer. Under these conditions, the method of coating comprises further steps that are aimed to:
- transfer the metal-containing film blank onto the target carrier,
- remove the protective layer of polymer,
- subject this metal-containing film blank to dehumidification once it has been transferred onto the target carrier,

The presence of the protective layer of polymer on the metal film enhances the film stiffness and thus makes it easier to transfer the film to the target carrier without mechanical damages. Thereby, the method, according to the invention, can be adapted to commercially produce the metal-containing film blank on a mass production basis, regardless of the operator qualification. The subsequent removal of the protective layer of polymer makes is possible to produce a target carrier coated with a homogeneous metal film, wherein said film is at the same time transparent (in the visible spectrum of radiation), current-conducting, and corrosion-resistant.

According to the third of its aspects, the invention relates to the use of the target carrier coated with a metal-containing film blank, in accordance with the coating method described above, as one of the following products: (a) transparent electrode; (b) thin-film solar cell; (c) photodetector; (d) light-emitting diode; (e) contact lens for an eye; (f) flat screen; (g) flexible screen; (h) touch screen; (i) electrochromic device; (j) gas sensor; (k) chemical sensor; (l) biological sensor; (m) film-type flexible nanoelectronic device.

This makes it possible to use the target carrier coated with the metal-containing film blank in various arts, which, in its turn, expands functionality of the invention.

Other characteristic features and advantages of the invention clearly follow from the description that is provided below by way of illustration and is not limiting, with the reference to the attached drawings, wherein:
- Figure 1 schematically represents the method of coating a target carrier with a metal-containing film blank, according to the invention;
- Figure 2 represents a schematic simplified cross-sectional side view of an example multilayer composite structure comprising a base, an underlying layer, a metal film and a protective layer of polymer;
- Figure 3 represents a schematic simplified cross-sectional side view of the step of immersion of the multilayer composite structure into the first liquid medium;
- Figure 4 represents a schematic simplified cross-sectional side view of the step of separation of the underlying layer from the base under the influence of electrolytic gas bubbles resulting from electrolysis within the first liquid medium;
- Figure 5 represents a schematic simplified cross-sectional side view of the step of flotation of a sandwich structure, containing an underlying layer, a metal film, and a protective layer of polymer, on the surface of the second liquid medium during the chemical etching of the underlying layer;
- Figure 6 represents a schematic simplified cross-sectional side view of the step of flotation of the metal film with the protective layer of polymer on the surface of distilled water during the removal of the products of chemical reactions;
- Figure 7 represents a schematic simplified cross-sectional side view of a target carrier coated with the metal film with the protective layer of polymer before its removal;
- Figure 8 represents a schematic simplified cross-sectional side view of a target carrier coated with the metal film after the removal of the protective layer of polymer;
- Figure 9 represents a top view of a photo of a segment of a metal film (coating the target carrier), taken using an electron microscope.

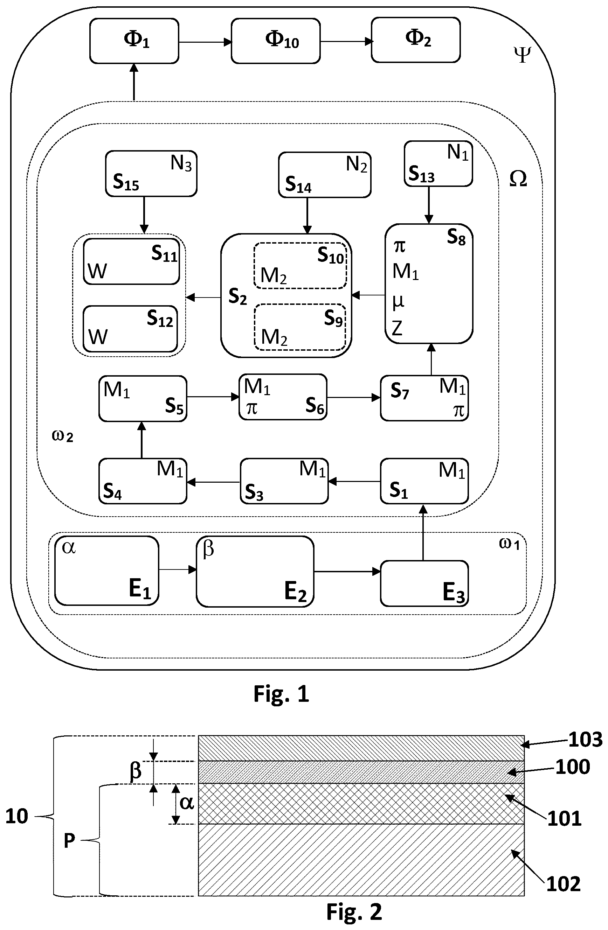

As shown in Figures 1-9, according to the first of its aspects, the invention relates to a method of producing Ω a metal-containing film blank adapted to be applied onto a target carrier 2. Wherein, the method of producing Ω comprises:
- the phase of forming ω₁ a multilayer composite structure 10 that includes a metal film 100, and
- the phase of destroying ω₂ this multilayer composite structure 10 to produce a metal-containing film blank 1.

Therewith, the phase of destroying ω₂ the multilayer composite structure 10 follows the phase of forming ω₁ the multilayer composite structure 10.

As shown in Fig. 1, the phase of forming ω₁ the multilayer composite structure 10 (Fig. 2) comprises further steps that are aimed to:
- apply E₁ the underlying layer 101 onto the base 102 to form a substrate layer P,
- deposit E₂ a metal onto the substrate layer P to form a multilayer composite structure 10 containing a metal film 100 bonded with the substrate layer P.

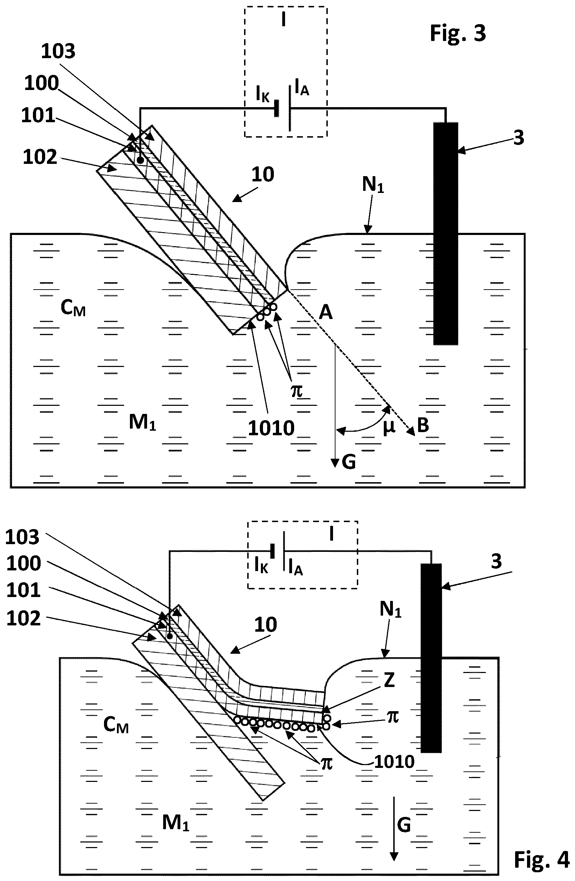

Also, as shown in Fig. 1, the phase of destroying ω₂ this multilayer composite structure 10 comprises further steps that are aimed to:
- place S₁ a part of the multilayer composite structure 10 into a first liquid medium M₁ (Fig. 3-4),
- destroy S₂ the underlying layer 101 (Fig. 4-5).

According to the invention, the underlying layer 101 contains copper. Under these conditions, the metal film 100 contains at least one metal from the following group of metals: (a) aurum; (b) argentum; (c) platinum-group metals (i.e. platinum, or ruthenium, or rhodium, or palladium, or osmium, or iridium).

Preferably, the first liquid medium M₁ contains electrolyte. Under these conditions, as shown in Fig. 1, the phase of destroying ω₂ the multilayer composite structure 10 additionally includes further steps that are aimed to:
- introduce S₃ into the first liquid medium M₁ the first electrode 3 that is different from the multilayer composite structure 10 (Fig. 3),
- form S₄ an anode by connecting the first electrode 3 to the positive pole I_{A} of an external direct current supply I (Fig. 3),
- form S₅ a cathode by connecting the underlying layer 101 to the negative pole I_{K} of said external direct current supply I, wherein the negative pole I_{K} is different from the positive pole I_{A} (Fig. 3),
- establish S₆ an electrolytic process inside the first liquid medium M₁ between the cathode and anode, with electrolytic gas bubbles π being produced inside the first liquid medium M₁ along the edge 1010 of the underlying layer 101 contacting the first liquid medium M₁ (Fig. 3-4),
- maintain S₇ said electrolytic process inside the first liquid medium M₁ between the cathode and anode to mechanically tear the underlying layer 101 by said electrolytic gas bubbles π away from the base 102 (Fig. 4),
- immerse S₈ the multilayer composite structure 10 into the first liquid medium M₁, while the underlying layer 101 is separating from the base 102, until the underlying layer 101 is fully separated from the base 102 and a sandwich structure Z is formed comprising the underlying layer 101 and the metal film 100 bonded together (Fig. 4).

Preferably, the electrolyte can consist of potassium chloride solution whose molar concentration C_{M} is contained within the range from 0.05 mol per liter to 7.6 mol per liter: 0.05 mol/l ≤ C_{M} ≤ 7.60 mol/l.

According to the first embodiment (Fig. 1) of the method of producing, according to the invention, the step of destroying S₂ the underlying layer 101 includes a further step that is aimed to replace S₉ the first liquid medium M₁ with a second liquid medium M₂ that is chemically aggressive to the underlying layer 101, to chemically etch the latter.

According to the second embodiment (Fig. 1) of the method of producing, according to the invention, which is alternative to the first embodiment described above: the step of destroying S₂ the underlying layer 101 includes a further step that is aimed to transfer S₁₀ the sandwich structure Z containing the underlying layer 101 and the metal film 100 bonded together from the first liquid medium M₁ into the second liquid medium M₂ that is chemically aggressive to the underlying layer 101, to chemically etch the latter.

Preferably, the second liquid medium M₂ consists of one of the following solutions: (a) ammonium persulphate solution; (b) sodium persulphate solution; (c) hydrogen peroxide and sodium persulphate solution; (d) sulphuric acid solution; (e) sulphuric acid and hydrogen peroxide solution.

According to the third embodiment (Fig. 1) of the method of producing, according to the invention, the phase of destroying ω₂ the multilayer composite structure 10 additionally includes a further step that is aimed to replace S₁₁ the second liquid medium M₂ with distilled water W to remove the products of chemical reactions.

According to the fourth embodiment of the method of producing, according to the invention, which is alternative to the third embodiment described above: the phase of destroying ω₂ the multilayer composite structure 10 additionally includes a further step that is aimed to transfer S₁₂ the metal film 100 from the second liquid medium M₂ into distilled water W to remove the products of chemical reactions.

As shown in Fig. 1, the phase of destroying ω₂ the multilayer composite structure 10 additionally includes a further step that is aimed to achieve S₁₃ flotation of the sandwich structure Z on the surface N₁ of the first liquid medium M₁ after the underlying layer 101 is completely separated from the base 102.

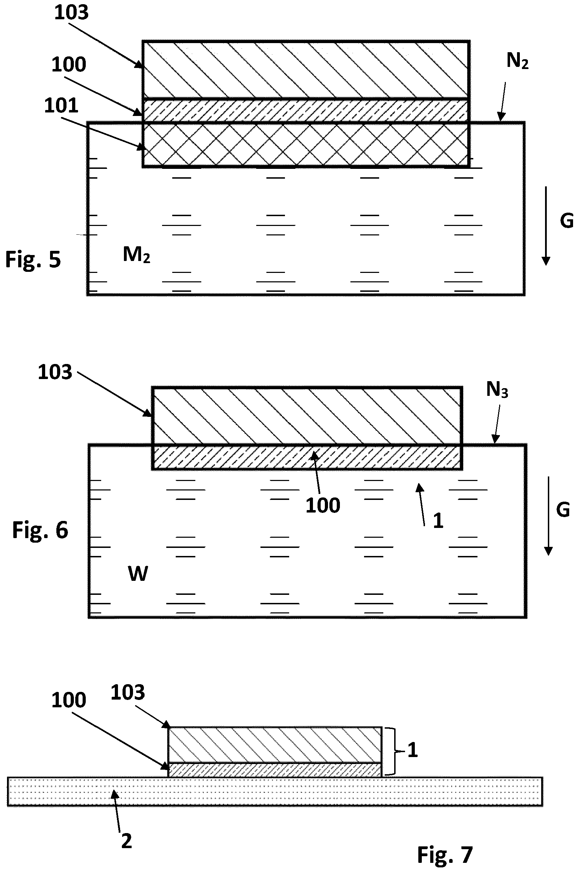

As shown in Fig. 1, the phase of destroying ω₂ the multilayer composite structure 10 additionally includes a further step that is aimed to achieve S₁₄ flotation of the sandwich structure Z on the surface N₂ of the second liquid medium M₂ during the chemical etching of the underlying layer 101 (Fig. 5).

As shown in Fig. 1, the phase of destroying ω₂ the multilayer composite structure 10 additionally includes a further step that is aimed to achieve S₁₅ flotation of the metal film 100 on the surface N₃ of distilled water W during the removal of the products of chemical reactions (Fig. 6).

Preferably, the base 102 contains one of the following materials: (a) a monocrystalline silicon wafer; (b) a monocrystalline silicon wafer with a layer of graphene pre-applied thereon; (c) a monocrystalline silicon wafer containing silicon oxide; (d) a monocrystalline silicon wafer containing silicon oxide, with a layer of graphene pre-applied thereon; (e) glass; (f) sapphire; (g) copper foil; (h) poly(4,4'-oxidiphenyl-pyromellitimide); (i) polyethyleneterephthalate; (j) polyether; (k) polypropylene; (l) polyethylene; (m) polyvinylchloride; (n) polystyrene; (o) polytetrafluoroethylene; (p) polymethylmethacrylate.

Preferably, the first thickness α of the underlying layer 101 is contained within the first range from 20 nanometers to 10,000 nanometers: 20 nm ≤ α ≤ 10,000 nm (Fig. 2). Under these conditions, the second thickness β of the metal film 100 is contained within the second range from 0.5 nanometers to 30 nanometers: 0.5 nm ≤ β ≤ 30 nm (Fig. 2).

As shown in Fig. 3-4, the immersion S₈ of the multilayer composite structure 10 into the first liquid medium M₁, while the underlying layer 101 is separating from the base 102, occurs along a guideline that makes the angle µ contained within the third range from 5° to 15° relative to the gravitational vector G: 5° ≤ µ ≤ 15°.

As shown in Fig. 1, the phase of forming ω₁ the multilayer composite structure 10 additionally includes a further step that is aimed to coat E₃ the metal film 100 with the protective layer 103 of polymer (Fig. 2).

Preferably, said polymer contains one of the following materials: (a) polymethylmethacrylate; (b) polydimethylsiloxane, (c) polycarbonate, (d) polylactide; (e) polyphthalamide; (f) bisphenol A.

As shown in figures 1, 8-9, according to the second of its aspects, the invention relates to a method of coating Ψ a target carrier 2 with a metal-containing film blank 1 produced in accordance with the method of producing Ω described above. Said method of coating Ψ comprises further steps that are aimed to:
- transfer Φ₁ the metal-containing film blank 1 onto the target carrier 2,
- subject Φ₂ this metal-containing film blank 1 to dehumidification after it has been transferred Φ₁ onto the target carrier 2.

As shown in figures 1, 7-9, according to the third of its aspects, the invention relates to a method of coating Ψ the target carrier 2 with a metal-containing film blank 1 produced in accordance with the method of producing Ω described above, wherein the phase of forming ω₁ the multilayer composite structure 10 additionally includes a further step that is aimed to coat E₃ the metal film 100 with a protective layer 103 of polymer (Fig. 2).

Preferably, said polymer contains one of the following materials: (a) polymethylmethacrylate; (b) polydimethylsiloxane, (c) polycarbonate, (d) polylactide; (e) polyphthalamide; (f) bisphenol A.

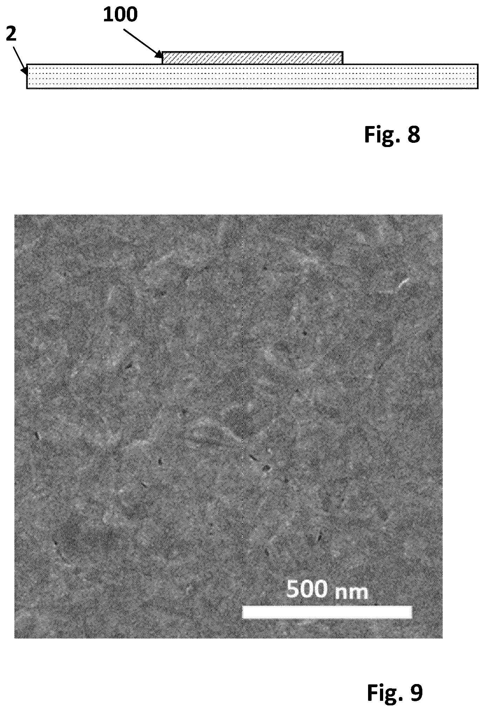

Under these conditions, the method of coating Ψ comprises further steps that are aimed to:
- transfer Φ₁ the metal-containing film blank 1 onto the target carrier 2 (Fig. 7),
- remove Φ₁₀ the protective layer 103 of polymer,
- subject Φ₂ this metal-containing film blank 1 to dehumidification after it has been transferred Φ₁ onto the target carrier 2 (Fig. 8-9).

According to the fourth of its aspects, the invention relates to the use of the target carrier 2, coated with a metal-containing film blank 1 (Fig. 8) in accordance with the method of coating Ψ described above, as one of the following products: (a) transparent electrode; (b) thin-film solar cell; (c) photodetector; (d) light-emitting diode; (e) contact lens for an eye; (f) flat screen; (g) flexible screen; (h) touch screen; (i) electrochromic device; (j) gas sensor; (k) chemical sensor; (l) biological sensor; (m) film-type flexible nanoelectronic device.

Thus, the technical effect of the claimed invention consists in producing a thin (i.e. less than 0.5 micrometer thick, generally several tens of nanometers) metal film that contains at least one metal from the following group of metals: (a) aurum; (b) argentum; (c) platinum-group metals (i.e. platinum, or ruthenium, or rhodium, or palladium, or osmium, or iridium), and at the same time is:
- smooth, i.e. homogeneous in thickness, without mechanical damages like warping, clumping, conglutination,
- solid and cohesive, i.e. without mechanical disruptions.

Under these conditions, said metal film is transparent in the optical band of the light spectrum visible to the human eye and at the same time carries electrical current. Furthermore, said metal film is adapted to be transferred onto a target carrier by choosing for the underlying material a soluble layer of copper having high adhesive properties towards a metal from the following group of metals: (a) aurum; (b) argentum; (c) platinum-group metals (i.e. platinum, or ruthenium, or rhodium, or palladium, or osmium, or iridium).

**Example 1.** Coating a target carrier with a metal film produced from a metal-containing film blank that is formed by destroying a multilayer composite structure on a base consisting of a monocrystalline silicon wafer.

For the base (i.e. substrate layer), a monocrystalline silicon wafer is chosen that is used in microelectronics and manufactured as per ETO.035.206 TY specification. Then, on this base a multilayer composite structure is formed. For this purpose, initially the underlying layer of copper having the film thickness in the range from 0.1 micrometer to 0.5 micrometer is applied onto the base using the electron-beam evaporation technique. Then, a film of aurum having the thickness in the range from 3 nanometers to 10 nanometers is precipitated (deposited) onto the underlying layer of copper using the same electron-beam evaporation technique. After that, the aurum film is coated with a protective layer of polymethylmethacrylate polymer using the centrifugation process. Thus, the multilayer composite structure has been produced.

Then, potassium chloride salts are dissolved in water in order to produce an electrolyte whose molar concentration is contained within the range from 0.5 mol per liter to 2.0 mol per liter.

An anode is introduced into the electrolyte. The multilayer composite structure is immersed into the electrolyte as well: under these conditions, its underlying layer of copper forms a cathode.

Once a voltage is applied to the anode and cathode, in the electrolyte an electrochemical reaction of electrolysis is observed resulting in that electrolytic gas (hydrogen) bubbles are produced along the edge of the underlying copper layer. Gradually penetrating between the base and the underlying copper layer, these electrolytic gas (hydrogen) bubbles cause the underlying copper layer to mechanically tear away from the base. As a result, a sandwich structure is formed consisting of the underlying copper layer, aurum film, and protective layer of polymethylmethacrylate, wherein said sandwich structure is floating, i.e. is held on the surface of electrolyte by the surface tension forces and by the Archimedes force that acts upon the produced hydrogen bubbles during the electrolytic process.

To remove the underlying copper layer, the sandwich structure is moved from the surface of electrolyte onto the surface of ammonium persulphate aqueous solution whose molar concentration is 0.1 mol per liter. After the chemical etching, the underlying copper layer disappears: on the surface of ammonium persulphate aqueous solution, only the aurum film coated with the protective layer of polymethylmethacrylate remains floating.

To remove the products of chemical reactions, the aurum film coated with the protective layer of polymethylmethacrylate is moved from the surface of ammonium persulphate aqueous solution onto the surface of distilled water.

After flotation on the surface of distilled water, the aurum film coated with the protective layer of polymethylmethacrylate is transferred onto the target carrier. Then, the protective layer of polymethylmethacrylate is removed using a suitable solvent, for example, using acetone, or using isopropanol, or using a mixture of acetone and isopropanol.

The produced aurum film can be additionally fixed on the target carrier by means of dehumidification.

Upon completion of all these manipulations, the aurum film:
- reliably coats the target carrier,
- has no mechanical defects, damages, disruptions, i.e. demonstrates the expected solidity and low roughness,
- is transparent in the optical band of the light spectrum visible to the human eye,
- carries electrical current.

**Example 2.** Coating a target carrier with a metal film produced from a metal-containing film blank that is formed by destroying a multilayer composite structure on a base consisting of a monocrystalline silicon wafer with a layer of graphene pre-applied thereon.

Initially, a base is produced. For this purpose, using the standard laboratory techniques, a layer of graphene is applied onto the surface of a monocrystalline silicon wafer used in microelectronics and manufactured as per ETO.035.206 TY specification. Then, on this base, consisting of the monocrystalline silicon wafer with the layer of graphene pre-applied thereon, a multilayer composite structure is formed. For this purpose, the electron-beam evaporation technique is used to successively apply an underlying layer of copper having the film thickness from 0.1 micrometer to 0.5 micrometer, onto whose surface using the same technique a film of aurum having the thickness from 3 nanometers to 10 nanometers is precipitated. The obtained structure is coated with a protective layer of polymethylmethacrylate polymer using the centrifugation process.

The subsequent steps are similar to those described above in Example 1.

The presence of graphene decreases roughness on the "base/underlying copper layer" interface surface. This, in its turn, makes it easier and faster for the underlying copper layer to tear away from the base during the electrolytic process. In practice, such tearing-away occurs at lower cathode voltages as opposed to those voltages that were needed to achieve such tearing-away in Example 1. This contributes to power saving and enables more accurate current monitoring during the electrolytic process. Furthermore, the metal (aurum) film in Example 2 as well demonstrates lower roughness than the roughness demonstrated by the metal (aurum) film in Example 1. Owing to said lower roughness, the metal (aurum) film in Example 2 demonstrates better (as compared with the film of Example 1) solidity, transparency, electrical conductivity. According to the applicant's estimations, such improvements in terms of transparency and electrical conductivity comprise approximately (depending on the film thickness) +10% as compared with the corresponding characteristics of the film of Example 1.

**Example 3.** Coating the target carrier with a metal film produced from a metal-containing film blank that is formed by destroying a multilayer composite structure on a base consisting of a copper foil.

Using the electron-beam evaporation technique, the following is successively applied onto the surface of the base (i.e. substrate layer) consisting of a copper foil: an underlying layer of copper having the thickness from 0.1 micrometer to 0.5 micrometer and a layer of aurum having the thickness from 3 nanometers to 10 nanometers. After that, the layer of aurum is coated with polymethylmethacrylate polymer using the centrifugation process. The subsequent steps are similar to those described above in Example 1. The method of producing the metal film and using it to coat the target carrier as per Example 3 is technologically easier than the method described in Example 1 above.

## Claims

1. A method of producing (Ω) a metal-containing film blank (1) adapted to be applied onto a target carrier (2), wherein said method of producing (Ω) comprises:
• the phase of forming (ω₁) a multilayer composite structure (10) that includes a metal film (100), and
• the phase of destroying (ω₂) this multilayer composite structure (10) to produce a metal-containing film blank (1), following the phase of forming thereof (ω₁),
therewith, the phase of forming (ω₁) the multilayer composite structure (10) comprises further steps that are aimed to:
• apply (E₁) the underlying layer (101) onto the base (102) to form a substrate layer (P),
• deposit (E₂) a metal onto the substrate layer (P) to form a multilayer composite structure (10) containing a metal film (100) bonded with the substrate layer (P),
therewith, the phase of destroying (ω₂) this multilayer composite structure (10) comprises further steps that are aimed to:
• place (S₁) a part of the multilayer composite structure (10) into a first liquid medium (M₁),
• destroy (S₂) the underlying layer (101),
**characterized in that** the underlying layer (101) contains copper, and
**in that** the metal film (100) contains at least one metal from the following group of metals: (a) aurum; (b) argentum; (c) platinum; (d) ruthenium; (e) rhodium; (f) palladium; (g) osmium; (h) iridium.

2. The method of producing (Ω) a metal-containing film blank (1) according to claim 1, **characterized in that** the first liquid medium (M₁) contains electrolyte,
**in that** the phase of destroying (ω₂) the multilayer composite structure (10) additionally includes further steps that are aimed to:
• introduce (S₃) into the first liquid medium (M₁) the first electrode (3) that is different from the multilayer composite structure (10),
• form (S₄) an anode by connecting the first electrode (3) to the positive pole (I_{A}) of an external direct current supply (I),
• form (S₅) a cathode by connecting the underlying layer (101) to the negative pole (I_{K}) of said external direct current supply (I), wherein the negative pole (I_{K}) is different from the positive pole (I_{A}),
• establish (S₆) an electrolytic process inside the first liquid medium (M₁) between the cathode and anode, with electrolytic gas bubbles (π) being produced inside the first liquid medium (M₁) along the edge (1010) of the underlying layer (101) contacting the first liquid medium (M₁),
• maintain (S₇) said electrolytic process inside the first liquid medium (M₁) between the cathode and anode to mechanically tear the underlying layer (101) by said electrolytic gas bubbles (π) away from the base (102),
• immerse (S₈) the multilayer composite structure (10) into the first liquid medium (M₁), while the underlying layer (101) is separating from the base (102), until the underlying layer (101) is fully separated from the base (102) and a sandwich structure (Z) is formed comprising the underlying layer (101) and the metal film (100) bonded together.

3. The method of producing (Ω) a metal-containing film blank (1) according to claim 2, **characterized in that** the electrolyte consists of potassium chloride solution whose molar concentration is contained within the range from 0.05 mol per liter to 7.6 mol per liter.

4. The method of producing (Ω) a metal-containing film blank (1) according to claim 3, **characterized in that** the step of destroying (S₂) the underlying layer (101) includes a further step that is aimed to replace (S₉) the first liquid medium (M₁) with a second liquid medium (M₂) that is chemically aggressive to the underlying layer (101), to chemically etch the latter.

5. The method of producing (Ω) a metal-containing film blank (1) according to claim 4, **characterized in that** the step of destroying (S₂) the underlying layer (101) includes a further step that is aimed to transfer (S₁₀) the sandwich structure (Z) containing the underlying layer (101) and the metal film (100) bonded together from the first liquid medium (M₁) into the second liquid medium (M₂) that is chemically aggressive to the underlying layer (101), to chemically etch the latter.

6. The method of producing (Ω) a metal-containing film blank (1) according to claim 5, **characterized in that** the second liquid medium (M₂) consists of one of the following solutions: (a) ammonium persulphate solution; (b) sodium persulphate solution; (c) hydrogen peroxide and sodium persulphate solution; (d) sulphuric acid solution; (e) sulphuric acid and hydrogen peroxide solution.

7. The method of producing (Ω) a metal-containing film blank (1) according to claim 6, **characterized in that** the phase of destroying (ω₂) the multilayer composite structure (10) additionally includes a further step that is aimed to replace (S₁₁) the second liquid medium (M₂) with distilled water (W) to remove the products of chemical reactions.

8. The method of producing (Ω) a metal-containing film blank (1) according to claim 6, **characterized in that** the phase of destroying (ω₂) the multilayer composite structure (10) additionally includes a further step that is aimed to transfer (S₁₂) the metal film (100) from the second liquid medium (M₂) into distilled water (W) to remove the products of chemical reactions.

9. The method of producing (Ω) a metal-containing film blank (1) according to claim 8, **characterized in that** the phase of destroying (ω₂) the multilayer composite structure (10) additionally includes a further step that is aimed to achieve (S₁₃) flotation of the sandwich structure (Z) on the surface (N₁) of the first liquid medium (M₁) after the underlying layer (101) is completely separated from the base (102).

10. The method of producing (Ω) a metal-containing film blank (1) according to claim 9, **characterized in that** the phase of destroying (ω₂) the multilayer composite structure (10) additionally includes a further step that is aimed to achieve (S₁₄) flotation of the sandwich structure (Z) on the surface (N₂) of the second liquid medium (M₂) during the chemical etching of the underlying layer (101).

11. The method of producing (Ω) a metal-containing film blank (1) according to claim 10, **characterized in that** the phase of destroying (ω₂) the multilayer composite structure (10) additionally includes a further step that is aimed to achieve (S₁₅) flotation of the metal film (100) on the surface (N₃) of distilled water (W) during the removal of the products of chemical reactions.

12. The method of producing (Ω) a metal-containing film blank (1) according to claim 1, **characterized in that** the base (102) contains one of the following materials: (a) a monocrystalline silicon wafer; (b) a monocrystalline silicon wafer with a layer of graphene pre-applied thereon; (c) a monocrystalline silicon wafer containing silicon oxide; (d) a monocrystalline silicon wafer containing silicon oxide, with a layer of graphene pre-applied thereon; (e) glass; (f) sapphire; (g) copper foil; (h) poly(4,4'-oxidiphenyl-pyromellitimide); (i) polyethyleneterephthalate; (j) polyether; (k) polypropylene; (l) polyethylene; (m) polyvinylchloride; (n) polystyrene; (o) polytetrafluoroethylene; (p) polymethylmethacrylate.

13. The method of producing (Ω) a metal-containing film blank (1) according to claim 1, **characterized in that** the first thickness (α) of the underlying layer (101) is contained within the first range from 20 nanometers to 10,000 nanometers, and
**in that** the second thickness (β) of the metal film (100) is contained within the second range from 0.5 nanometers to 30 nanometers.

14. The method of producing (Ω) a metal-containing film blank (1) according to claim 2, **characterized in that** the immersion (S₈) of the multilayer composite structure (10) into the first liquid medium (M₁), while the underlying layer (101) is separating from the base (102), occurs along a guideline that makes the angle (µ) contained in the third range from 5° to 15° relative to the gravitational vector (G).

15. The method of producing (Ω) a metal-containing film blank (1) according to claim 1, **characterized in that** the phase of forming (ω₁) the multilayer composite structure (10) additionally includes a further step that is aimed to coat (E₃) the metal film (100) with a protective layer (103) of polymer.

16. The method of producing (Ω) a metal-containing film blank (1) according to claim 15, **characterized in that** the polymer contains one of the following materials: (a) polymethylmethacrylate; (b) polydimethylsiloxane, (c) polycarbonate, (d) polylactide; (e) polyphthalamide; (f) bisphenol A.

17. A method of coating (Ψ) the target carrier (2) with a metal-containing film blank (1) produced in accordance with the method of producing (Ω) as per claim 1, wherein said method of coating (Ψ) comprises further steps that are aimed to:
• transfer (Φ₁) the metal-containing film blank (1) onto the target carrier (2),
• subject (Φ₂) this metal-containing film blank (1) to dehumidification once it has been transferred (Φ₁) onto the target carrier (2).

18. The method of coating (Ψ) the target carrier (2) with a metal-containing film blank (1) produced in accordance with the method of producing (Ω) as per claim 15, wherein said method of coating (Ψ) comprises further steps that are aimed to:
• transfer (Φ₁) the metal-containing film blank (1) onto the target carrier (2),
• remove (Φ₁₀) the protective layer (103) of polymer,
• subject this metal-containing film blank (1) to dehumidification (Φ₂) once it has been transferred (Φ₁) onto the target carrier (2).

19. The use of the target carrier (2), coated with the metal-containing film blank (1) in accordance with the method of coating (Ψ) as per claim 17, as one of the following products: (a) transparent electrode; (b) thin-film solar cell; (c) photodetector; (d) light-emitting diode; (e) contact lens for an eye; (f) flat screen; (g) flexible screen; (h) touch screen; (i) electrochromic device; (j) gas sensor; (k) chemical sensor; (l) biological sensor; (m) film-type flexible nanoelectronic device.

20. The use of the target carrier (2), coated with the metal-containing film blank (1) in accordance with the method of coating (Ψ) as per claim 18, as one of the following products: (a) transparent electrode; (b) thin-film solar cell; (c) photodetector; (d) light-emitting diode; (e) contact lens for an eye; (f) flat screen; (g) flexible screen; (h) touch screen; (i) electrochromic device; (j) gas sensor; (k) chemical sensor; (l) biological sensor; (m) film-type flexible nanoelectronic device.
